(19) Europäisches Patentamt / European Patent Office / Office européen des brevets

(11) **EP 4 148 445 B1**

(12) **EUROPEAN PATENT SPECIFICATION**

(45) Date of publication and mention of the grant of the patent:
**06.03.2024 Bulletin 2024/10**

(21) Application number: **22176665.2**

(22) Date of filing: **01.06.2022**

(51) International Patent Classification (IPC):
**G01R 31/389** (2019.01)   **G01R 27/26** (2006.01)

(52) Cooperative Patent Classification (CPC):
**G01R 31/389; G01R 27/2611; Y02E 60/10**

(54) **ESTIMATION METHOD FOR ASSEMBLED BATTERY, DATA PROCESSING DEVICE, AND NON-TRANSITORY STORAGE MEDIUM**

SCHÄTZVERFAHREN FÜR ZUSAMMENGESETZTE BATTERIE, DATENVERARBEITUNGSVORRICHTUNG UND NICHTFLÜCHTIGES SPEICHERMEDIUM

PROCÉDÉ D'ESTIMATION DE BATTERIE ASSEMBLÉE, DISPOSITIF DE TRAITEMENT DE DONNÉES ET SUPPORT DE STOCKAGE NON TRANSITOIRE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **10.09.2021 JP 2021148104**

(43) Date of publication of application:
**15.03.2023 Bulletin 2023/11**

(73) Proprietor: **Toyota Technical Development Corporation**
**Toyota, Aichi 470-0334 (JP)**

(72) Inventors:
• **MORIYAMA, Yasuyuki**
  **TOYOTA, AICHI, 470-0334 (JP)**
• **IWASE, Toshitaka**
  **TOYOTA, AICHI, 470-0334 (JP)**
• **SHIBATA, Toru**
  **TOYOTA, AICHI, 470-0334 (JP)**
• **NAKATSUKA, Yuji**
  **TOYOTA, AICHI, 470-0334 (JP)**
• **SUDA, Mitsutoshi**
  **TOYOTA, AICHI, 470-0334 (JP)**

(74) Representative: **Winter, Brandl - Partnerschaft mbB**
**Alois-Steinecker-Straße 22**
**85354 Freising (DE)**

(56) References cited:
**US-A1- 2006 017 447      US-A1- 2012 015 222**
**US-A1- 2014 315 047      US-A1- 2015 198 675**
**US-A1- 2019 271 747**

**Description**

BACKGROUND OF THE INVENTION

1. Field of the Invention

The present disclosure relates to estimation methods for assembled batteries, data processing devices, and non-transitory storage media.

2. Description of Related Art

Electrified vehicles such as battery electric vehicles have been increasingly used in recent years. Since secondary cells are used in electrified vehicles, attempts have been made to evaluate the characteristics of the secondary cells. For example, an information processing device described in Japanese Unexamined Patent Application Publication No. 2019-191030 (JP 2019-191030 A) measures the alternating current (AC) impedance of secondary cells, plots the real component and imaginary component of the AC impedance on frequency characteristic diagrams that are board plots, acquires polynomial curves by fitting to the plot results, converts the polynomial curves to an impedance curve on a Nyquist diagram, extracts circuit constants of an equivalent circuit from the impedance curve, and evaluates the characteristics of the equivalent circuit from the circuit constants. The circuit constants are a resistance component, a capacitance component, and an internal inductance component. Further prior art is found in US2014/315047, US2015/198675, US2019/271747, US2006/017447, and US2012/015222.

SUMMARY OF THE INVENTION

Electrical LC circuit resonance is sometimes a problem in an electric circuit of a powertrain of an electrified vehicle. In order to avoid the LC circuit resonance, it is important to know the values of inductance and capacitance at the design stage and reflect those values in the design of the electric circuit. However, there is no known method to accurately know the value of the inductance before producing an assembled battery composed of a plurality of secondary cells. The inductance as used herein includes the internal inductance of the secondary cells and the external inductance of a circuit connected to the secondary cells.

The present disclosure provides an estimation method for an assembled battery that estimates inductance, a data processing device, and a non-transitory storage medium.

A first aspect of the present disclosure relates to an estimation method for an assembled battery. The estimation method includes: a first step of measuring first inductance of a first path, the first path including a predetermined number of units of battery cells and a wire connected to the battery cells; a second step of deriving a calculation formula for calculating second inductance of a second path on an assumption that a current flowing through the predetermined number of units of the battery cells is an imaginary current line, the second path including the imaginary current line and a wire connected to the imaginary current line; a third step of determining a second variable by adjusting the second inductance obtained from the calculation formula to the first inductance measured in the first step by varying a first variable of the calculation formula derived in the second step; and a fourth step of estimating self-inductance according to a wire of the assembled battery and the number of the battery cells by using the second variable determined in the third step.

A second aspect of the present disclosure relates to a data processing device. The data processing device includes: an acquisition unit configured to acquire measurement information on measured first inductance of a first path and assembled battery information, the first path including a predetermined number of units of battery cells and a wire connected to the battery cells; a derivation unit configured to derive a calculation formula for calculating second inductance of a second path on an assumption that a current flowing through the predetermined number of units of the battery cells is an imaginary current line, the second path including the imaginary current line and a wire connected to the imaginary current line; a determination unit configured to determine a second variable by adjusting the second inductance obtained from the calculation formula to the first inductance that is based on the measurement information acquired by the acquisition unit by varying a first variable of the calculation formula derived by the derivation unit; and an estimation unit configured to estimate self-inductance according to a wire of an assembled battery and the number of the battery cells by using the second variable determined by the determination unit.

A third aspect of the present disclosure relates to a non-transitory storage medium. The non-transitory storage medium stores instructions that are executable by one or more processors and that cause the one or more processors to perform functions. The functions include: an acquisition function to acquire measurement information on measured first inductance of a first path and assembled battery information, the first path including a predetermined number of units of battery cells and a wire connected to the battery cells; a derivation function to derive a calculation formula for calculating second inductance of a second path on an assumption that a current flowing through the predetermined number of units of the battery cells is an imaginary current line, the second path including the imaginary current line and a wire connected to the imaginary current line; a determination function to determine a second variable by adjusting the second inductance obtained from the calculation formula to the first inductance that is based on the measurement information acquired by the acquisition function by varying a first variable of the calculation formula derived by the derivation function; and an estimation function to estimate self-inductance according to a wire of an assembled battery and the number of the battery cells by using the second variable determined by the determination function.

According to the above configuration, the calculation formula for calculating the inductance of the path including the imaginary current line and the wire connected to the imaginary current line is derived on the assumption that a current flowing through the predetermined number of units of the battery cells is the imaginary current line, the variable is determined by adjusting the inductance obtained from the calculation formula to the measured inductance by varying the function of the calculation formula, and the self-inductance according to the wire of the assembled battery and the number of the battery cells is estimated by using the determined variable.

BRIEF DESCRIPTION OF THE DRAWINGS

Features, advantages, and technical and industrial significance of exemplary embodiments of the invention will be described below with reference to the accompanying drawings, in which like signs denote like elements, and wherein:

FIG. 1 illustrates a data processing system according to an embodiment;
FIG. 2 is a block diagram illustrating a data processing device according to the embodiment;
FIG. 3 is a flowchart illustrating a data processing method according to the embodiment;
FIG. 4 is a first diagram illustrating the data processing method according to the embodiment;
FIG. 5 is a second diagram illustrating the data processing method according to the embodiment;
FIG. 6 is a third diagram illustrating the data processing method according to the embodiment;
FIG. 7A is a first diagram illustrating an example of obtaining internal inductance and is a first diagram illustrating a conductor etc.;
FIG. 7B is a first diagram illustrating an example of obtaining internal inductance and is a second diagram illustrating a conductor etc.;
FIG. 8A is a second diagram illustrating an example of obtaining internal inductance and is a first diagram illustrating a conductor and signs that are used when obtaining the internal inductance;
FIG. 8B is a second diagram illustrating an example of obtaining internal inductance and is a second diagram illustrating a conductor and signs that are used when obtaining the internal inductance;
FIG. 8C is a second diagram illustrating an example of obtaining internal inductance and is a third diagram illustrating a conductor and signs that are used when obtaining the internal inductance;
FIG. 9A is a diagram illustrating an example of deriving a calculation formula of self-inductance Lcal and is a first diagram illustrating coordinates etc. that are used when deriving the calculation formula;
FIG. 9B is a diagram illustrating an example of deriving a calculation formula of self-inductance Lcal and is a second diagram illustrating coordinates etc. that are used when deriving the calculation formula;
FIG. 9C is a diagram illustrating an example of deriving a calculation formula of self-inductance Lcal and is a third diagram illustrating coordinates etc. that are used when deriving the calculation formula;
FIG. 9D is a diagram illustrating an example of deriving a calculation formula of self-inductance Lcal and is a fourth diagram illustrating coordinates etc. that are used when deriving the calculation formula;
FIG. 10 is a fourth diagram illustrating the data processing method according to the embodiment; and
FIG. 11 is a fifth diagram illustrating the data processing method according to the embodiment.

DETAILED DESCRIPTION OF EMBODIMENTS

An embodiment will be described below.

Overview of Data Processing System 1

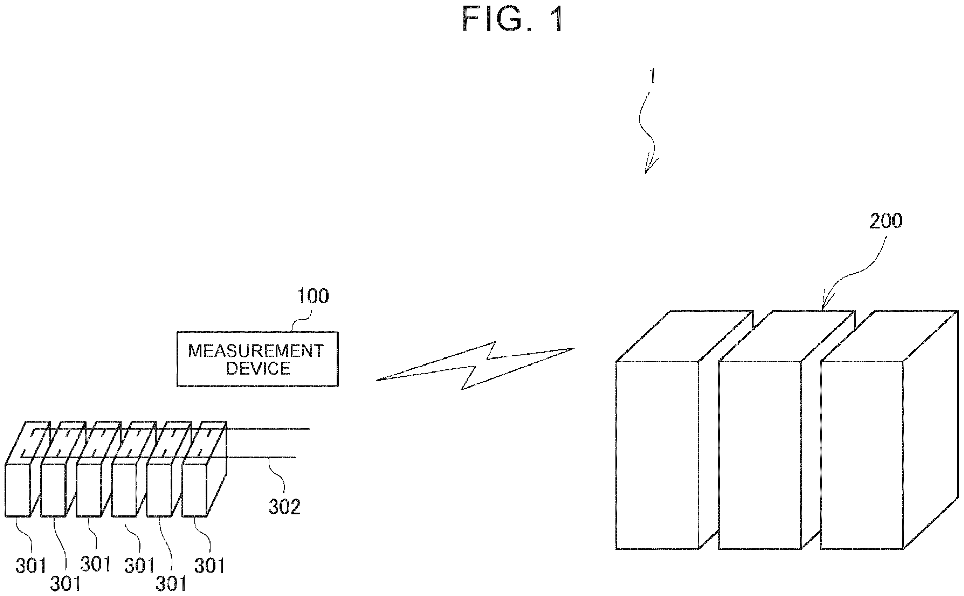

First, an overview of a data processing system 1 according to an embodiment will be provided. FIG. 1 illustrates the data processing system 1 according to the embodiment.

The data processing system 1 may include, for example, a measurement device 100 and a data processing device 200. The data processing system 1 may be, for example, an assembled battery inductance estimation system that estimates the inductance of a path including an assembled battery composed of a plurality of battery cells 301 such as secondary cells. The data processing device 200 may be, for example, an estimation device for the assembled battery that estimates the inductance of the assembled battery. A data processing program that is executed by the data processing system 1 may be, for example, an estimation program for the assembled battery that estimates the inductance of the assembled battery. A data processing method that is performed by the data processing system 1 may be, for example, an estimation method for the assembled battery that estimates the inductance of the assembled battery.

The measurement device 100 may be, for example, a device that measures the inductance of a path including the battery cells 301. As an example, the measurement device 100 may be a device that measures the inductance by various measurement methods such as an AC impedance method. The measurement device 100 may be, for example, a device that measures the inductance of a path including a predetermined number of units of battery cells 301. That is, the measurement device 100 measures the inductance of a path including a predetermined number of units of battery cells 301 forming the assembled battery and a wire 302 connected to the battery cells 301 (first step).

The data processing device 200 may be, for example, an inductance estimation device that estimates the inductance of a path including the assembled battery composed of the battery cells 301. The data processing device 200 may be, for example, a computer such as server, desktop, laptop, or tablet.

The data processing device 200 assumes that a current flowing through a predetermined number of units of battery cells 301 flows through an imaginary current line. That is, the data processing device 200 approximates the battery cells 301 themselves to an imaginary current line. The data processing device 200 derives a calculation formula for calculating the inductance of a path including the imaginary current line and a wire connected to the imaginary current line (second step). The calculation formula may be, for example, a formula for calculating the self-inductance including the internal inductance and external inductance of the path. The calculation formula may include variables. The variables may be, for example, the radius of the imaginary current line when the imaginary current line is assumed to be cylindrical, and the inductance of the imaginary current line (e.g., the internal inductance).

The data processing device 200 determines the variables by adjusting (fitting) the inductance (self-inductance) obtained from the calculation formula to the inductance measured in the first step by varying the variables in the calculation formula derived in the second step (third step). The data processing device 200 estimates the self-inductance according to the number of battery cells 301 in the assembled battery by using the variables determined in the third step (fourth step). For example, the data processing device 200 calculates the self-inductance according to the number of battery cells 301 in the assembled battery that is expected at the design stage, based on the self-inductance of the predetermined number of units of battery cells 301.

Details of Data Processing Device 200

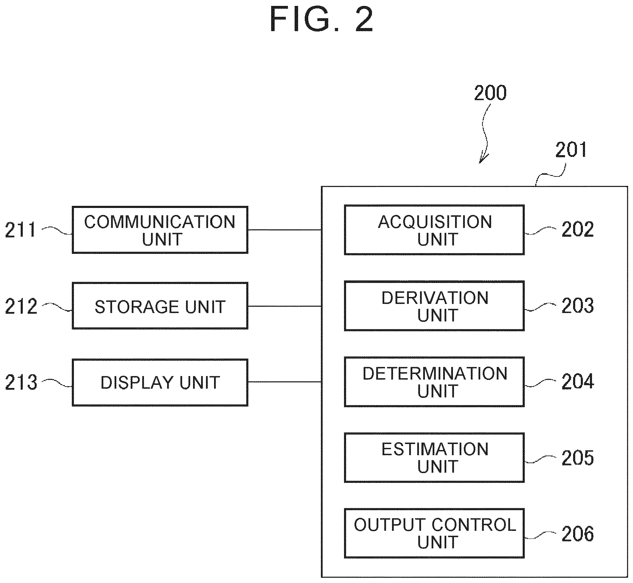

Next, the data processing device 200 according to the embodiment will be described in detail. FIG. 2 is a block diagram illustrating the data processing device 200 according to the embodiment.

The data processing device 200 includes, for example, a communication unit 211, a storage unit 212, a display unit 213, and a control unit 201. The communication unit 211, the storage unit 212, and the display unit 213 may be an embodiment of the output unit. The control unit 201 may function as, for example, an acquisition unit 202, a derivation unit 203, a determination unit 204, an estimation unit 205, and an output control unit 206. The control unit 201 may be, for example, an arithmetic processing unit of the data processing device 200. The control unit 201 (e.g., the arithmetic processing unit) may implement the functions of each unit (e.g., the acquisition unit 202, the derivation unit 203, the determination unit 204, the estimation unit 205, and the output control unit 206) by reading and executing various programs stored in the storage unit 212 etc. as appropriate.

The communication unit 211 can send and receive various kinds of information to and from, for example, a device outside the data processing device 200 (external device). The external device may be, for example, the measurement device 100. The communication unit 211 may receive, for example, the measurement result of the inductance (measurement information) from the measurement device 100. The external device may be, for example, a server or a user terminal (not shown). The user terminal may be, for example, a terminal used by a user of the data processing system 1. The user terminal may be, for example, a desktop, a laptop, a tablet, or a smartphone.

The storage unit 212 may store, for example, various kinds of information and programs. An example of the storage unit 212 may be a memory, a solid state drive, or a hard disk drive.

The display unit 213 can display, for example, various characters, symbols, and images.

The acquisition unit 202 acquires, for example, the measurement information that is the measurement result of the inductance from the measurement device 100. That is, the acquisition unit 202 acquires the measurement information on the inductance of the path including the predetermined number of units of battery cells 301 and the wire 302 connected to the battery cells 301. The acquisition unit 202 also acquires assembled battery information on the assembled battery composed of the battery cells 301. The assembled battery information may include, for example, various kinds of information such as the number of battery cells 301 in the assembled battery and the wiring condition (wiring route). The acquisition unit 202 may acquire the measurement information via, for example, the communication unit 211. In this case, the acquisition unit 202 may acquire the measurement information sent from the measurement device 100 as received by, for example, the communication unit 211. Alternatively, when, for example, the server as the external device acquires the measurement information from the measurement device 100 and stores it, the acquisition unit 202 may acquire the measurement information from the server as controlled by the control unit 201. Alternatively, when, for example, the measurement information generated by the measurement device 100 is stored in an external memory (not shown) etc. and the external memory is connected to an interface (not shown) of the data processing device 200, the acquisition unit 202 may acquire the measurement information from the external memory.

The measurement information is, for example, information on the measured inductance of the path including the predetermined number of units of battery cells 301 and the wire 302 connected to the battery cells 301 in the case where the battery cells 301 forming the assembled battery are divided into the predetermined number of units of battery cells 301 when estimating the self-inductance of the assembled battery. The wire 302 connected to the battery cells 301 may be a plurality of wiring patterns of the wire 302 to be measured. As an example, the measurement information may be information on the measured inductances of the paths including the battery cells 301 and the wire 302 connected to the battery cells 301, specifically the paths including the battery cells 301 and a plurality of patterns of the wire 302 with different distances from the battery cells 301. That is, the acquisition unit 202 may acquire the measurement results of the inductances measured using a plurality of wiring patterns of the wire 302 connected to the battery cells 301.

The derivation unit 203 assumes that a current flowing through a predetermined number of units of battery cells 301 is an imaginary current line, and derives a calculation formula for calculating the inductance of a path including the imaginary current line and the wire connected to the imaginary current line. This predetermined number of units of battery cells 301 is the same as the predetermined number of units of battery cells 301 measured by the measurement device 100 (first step). The derivation unit 203 derives the calculation formula on the assumption that the current flowing through the predetermined number of units of battery cells 301 flows through the imaginary current line. That is, the derivation unit 203 derives the calculation formula by approximating the predetermined number of units of battery cells 301 to the imaginary current line. The imaginary current line may be, for example, a wire through which a current is assumed to flow. The calculation formula derived by the derivation unit 203 may include a variable for the imaginary current line and a variable for the internal inductance of the battery cell 301. That is, in the derivation unit 203, the imaginary current line may be assumed to be cylindrical, and the variable for the imaginary current line may be the radius of the imaginary current line. The wire connected to the imaginary current line may correspond to a pattern of the wire connected to the battery cells 301 when the measurement device 100 measures the inductance. That is, the derivation unit 203 may derive the calculation formula by using, for example, the same condition as the pattern of the wire connected to the battery cells 301 when the measurement device 100 measures the inductance for the pattern of the wire connected to the imaginary current line. Namely, the derivation unit 203 may derive the following calculation formula (1) for deriving the inductance (self-inductance Lcal), where the variables are the radius R of the imaginary current line and the internal inductance Lint of the battery cell 301.

$$ \text{Lcal} = f(R,\ \text{Lint}) \qquad (1) $$

The determination unit 204 determines the variables by adjusting (fitting) the inductance obtained from the calculation formula to the inductance that is based on the measurement information acquired by the acquisition unit 202 by varying the variables of the calculation formula derived by the derivation unit 203. That is, the determination unit 204 fits (substantially fits) the inductance (self-inductance) obtained from the calculation formula to the inductance that is based on the measurement information by varying the variables of the calculation formula (e.g., the radius of the imaginary current line and the internal inductance of the battery cell 301) in the relationship of the inductance (self-inductance) according to the pattern of the wire connected to the battery cells 301 (imaginary current line). The determination unit 204 determines the variables (e.g., the radius of the imaginary current line and the internal inductance of the battery cell 301) when the inductance (self-inductance) obtained from the calculation formula is fitted (substantially fitted) to the inductance that is based on the measurement information.

The estimation unit 205 estimates the self-inductance according to the number of battery cells 301 in the path (assembled battery) by using the variables determined by the determination unit 204. The estimation unit 205 may calculate the external inductance of the path (assembled battery) based on the radius that is the variable for the imaginary current line determined by the determination unit 204. That is, the estimation unit 205 may calculate the external inductance of the assembled battery based on calculation of the flux linkage due to a current flowing in a closed circuit by using the radius of the imaginary current line. The estimation unit 205 calculates the internal inductance of the assembled battery by adding the internal inductance of the battery cell 301 determined by the determination unit 204 the same number of times as the number of battery cells 301 in the path (assembled battery). That is, the estimation unit 205 calculates the overall internal inductance of the assembled battery by multiplying the internal inductance determined by the determination unit 204 by the number of battery cells 301 forming the assembled battery (the predetermined number of units of battery cells 301 forming the assembled battery). The estimation unit 205 estimates the self-inductance (of the assembled battery) according to the wiring of the assembled battery and the number of battery cells 301 by adding the external inductance and internal inductance calculated as described above. The wiring (wiring route) of the assembled battery and the number of battery cells 301 may be acquired based on the assembled battery information.

The output control unit 206 controls the output unit to output the self-inductance estimated by the estimation unit 205. The output unit may be, for example, the communication unit 211, the storage unit 212, and the display unit 213 as described above. That is, for example, the output control unit 206 may control the communication unit 211 to send information on the self-inductance estimated by the estimation unit 205 to the external device. The output control unit 206 may control the storage unit 212 to store the information on the self-inductance estimated by the estimation unit 205. The output control unit 206 may control the display unit 213 to display the self-inductance estimated by the estimation unit 205.

Data Processing Method

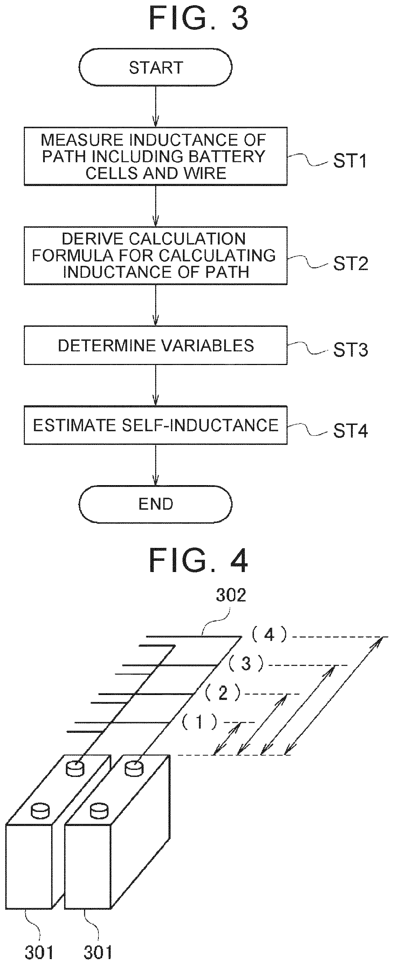

Next, an estimation method for the assembled battery that is a data processing method according to the embodiment will be described. FIG. 3 is a flowchart illustrating the data processing method according to the embodiment. FIGS. 4 to 6 are first to third diagrams illustrating the data processing method according to the embodiment.

In a first step (step ST1) shown in FIG. 3, the measurement device 100 measures the inductance of the path including the predetermined number of units of battery cells 301 and the wire 302 (see FIG. 4) connected to the battery cells 301 (see FIG. 4). In this case, the measurement device 100 measures the inductance using a plurality of wiring patterns of the wire 302 connected to the battery cells 301.

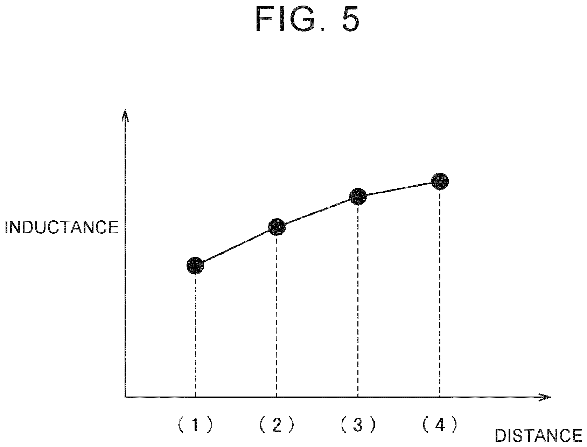

As an example, the measurement device 100 may measure the self-inductance using an AC impedance method by connecting the predetermined number of units of battery cells 301 forming the assembled battery in series. The predetermined number of units may be, for example, one, two, three, four, or five. In the example illustrated in FIG. 4, the measurement device 100 measures the self-inductance of two series battery cells 301. In this case, as illustrated in FIG. 4, the measurement device 100 measures the self-inductance using a plurality of wiring patterns of the wire 302 for measurement. As a specific example, as illustrated by (1) to (4) in FIG. 4, the measurement device 100 may measure a current and voltage for each of the wiring patterns with different distances of the wire 302, and may calculate the self-inductance for each wiring pattern by using an AC impedance method. FIG. 5 illustrates the calculation results of the self-inductance for the patterns (1) to (4) in FIG. 4. In FIG. 5, the abscissa represents the wiring distance (distance of the wire 302 in each pattern (1) to (4)), and the ordinate represents the inductance (self-inductance).

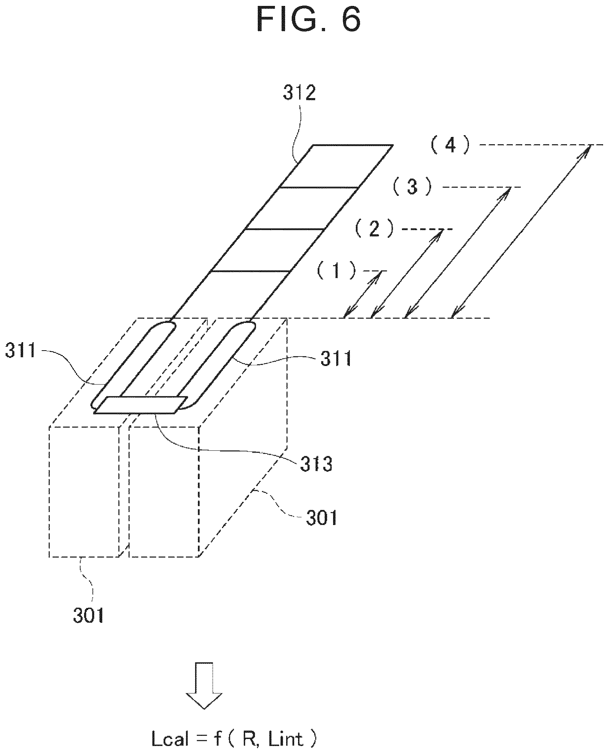

In a second step (step ST2) shown in FIG. 3, the derivation unit 203 of the data processing device 200 approximates the predetermined number of units of battery cells 301 to an imaginary current line 311 (see FIG. 6), and derives a calculation formula for calculating the inductance of a path including the imaginary current line 311 and a wire 312 (see FIG. 6) connected to the imaginary current line 311. The calculation formula may include a variable for the imaginary current line 311 and a variable for the internal inductance of the battery cell 301. In this case, the outer shape of the imaginary current line 311 may be assumed to be cylindrical, and the variable for the imaginary current line 311 may be the radius of the imaginary current line 311.

That is, as illustrated in FIG. 6, the derivation unit 203 may approximate the outer shape of the battery cell 301 to the cylindrical imaginary current line 311 and may use the radius of the imaginary current line 311 as a variable R. The derivation unit 203 derives the relational formula of the external inductance from the calculation of the flux linkage due to a current flowing in the closed circuit, under the same conditions as in the first step (e.g., the wiring patterns (1) to (4)). By using the internal inductance of the battery cell 301 as a variable Lint, the derivation unit 203 then derives the self-inductance Lcal of the predetermined number of units of (e.g., two series) battery cells 301 as a relational formula of R and Lint by adding the internal inductance of the battery cell 301 to the derived external inductance.

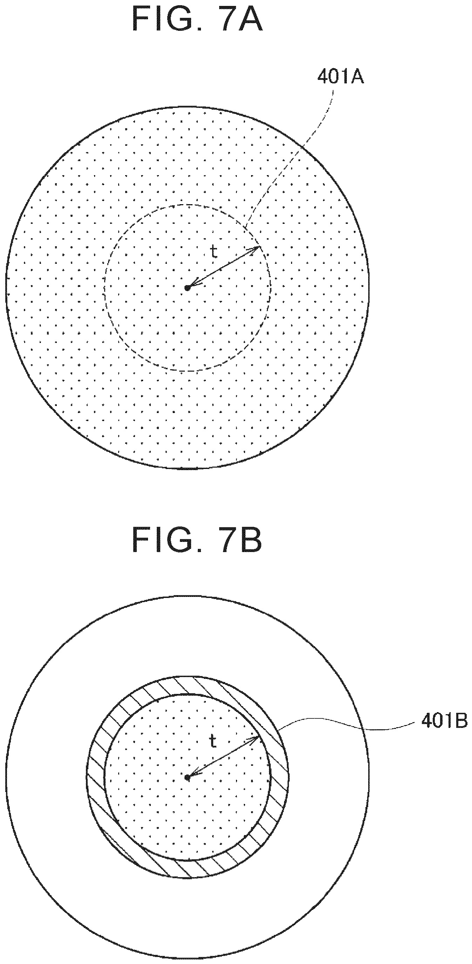

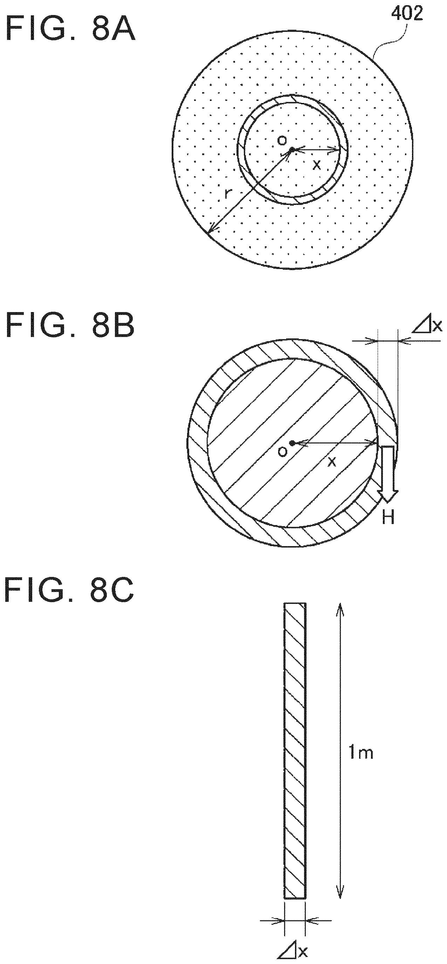

FIGS. 7A to 8C are first and second diagrams illustrating a typical example of obtaining the internal inductance. FIGS. 7A and 7B are first and second diagrams illustrating a conductor etc. FIGS. 8A to 8C are first to third diagrams illustrating a conductor and signs that are used when obtaining the internal inductance.

The internal inductance of the self-inductance is the inductance generated by the linkage between the magnetic flux generated inside the conductor and the current inside the conductor, and depends only on the length when the current distribution is uniform. As an example, when it is assumed that a current flows uniformly inside a straight conductor as illustrated in FIG. 7A, a magnetic flux is generated in a concentric pattern in a portion 401B inside the cylindrical conductor by a current flowing through a portion 401A inside the conductor as illustrated in FIG. 7B . The inductance therefore exists due to the linkage between the current and the magnetic field. For example, such internal inductance of the conductor can be obtained as follows. As illustrated in FIG. 8A, flux linkage $\Delta\psi$ in a portion inside a conductor 402, specifically a portion with a radius of x (m) from the center o of the conductor 402, due to a current i' is given by the following formula (2). In the formula (2), B (T) represents the density of the magnetic flux passing through a section (backslash hatched area in FIGS. 8A to 8C) $\Delta S$ of a portion with a very small thickness $\Delta x$ (m) and a length 1 (m) perpendicular to the figure, i' (A) represents a current flowing through a portion inside the section (forward slash hatched area in FIG. 8B), and μ represents the magnetic permeability of the conductor. It is herein assumed that a current flows uniformly through the conductor section.

$$\Delta\Psi = \text{n}'\text{B}\Delta\text{S} = \frac{\mu i}{2\pi r^4}\chi^3\Delta x \qquad (2)$$

The flux linkage ψ inside the conductor is given by the following formula (3) using Δψ.

$$\Psi = \int_{x=0}^{r} d\Psi = \frac{\mu i}{8\pi} \qquad (3)$$

Therefore, the self-inductance Lint inside one conductor of a length of 1 (m) is given by the following formula (4).

$$L_{int} = \frac{\Psi l}{i} = \frac{\mu l}{8\pi} \qquad (4)$$

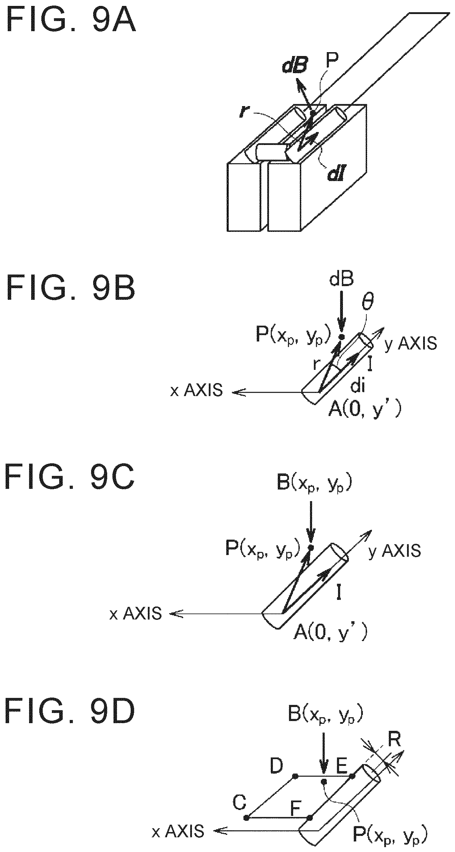

FIGS. 9A to 9D illustrate an example of deriving a calculation formula of the self-inductance Lcal suitable for the present disclosure. FIGS. 9A to 9D are first to fourth diagrams illustrating the coordinates etc. that are used when deriving the calculation formula. In FIG. 9A, P represents a given point on a plane including the imaginary current line, dB represents a magnetic flux density vector at the point P, dl represents a current vector, and r represents a length vector from dl to the point P. In FIG. 9B, P represents a given point on an xy plane, $x_p$ represents the x coordinate of the point P, $y_p$ represents the y coordinate of the point P, A represents a point on the center of the imaginary current line, and y' represents the y coordinate of the point A, dB represents the magnetic flux density (Z direction) at the point P caused by a very small current di, I represents a current, di represents a very small current, and r represents the length from the point A to the point P. In FIG. 9C, B represents the magnetic flux density (Z direction) at the point P caused by the imaginary current line. In FIG. 9D, R represents the radius of the imaginary current line, C represents the coordinates $(x_R + L_x, y_R)$, D represents the coordinates $(x_R + L_x, y_R + L_y)$, E represents the coordinates $(x_R, y_R + L_y)$, and F represents the coordinates $(x_R, y_R)$.

When deriving the calculation formula of the self-inductance Lcal, the magnetic flux density at the point on the center of the imaginary current line 311 is first calculated as illustrated in FIG. 9A. According to the Biot-Savart law, the magnetic flux density at the point P caused by the very small current vector dl can be given by the following formula (5), where μ0 represents the magnetic permeability of vacuum.

$$d\boldsymbol{B} = \mu_0 d\boldsymbol{H} = \frac{\mu_0 d\boldsymbol{l}}{4\pi r^2} \times \left(\frac{r}{r}\right) \qquad (5)$$

Considering the predetermined number of battery cells 301 (e.g., two series battery cells) approximated to the imaginary current line 311, the magnetic flux density at the point P is caused by two imaginary current lines 311, three wires 312, and one bus bar 313. As illustrated in FIG. 9B, the magnetic flux density from the point A on one imaginary current line 311 to the point P on the closed loop (inside the current path) due to the very small current di is obtained from the following formula (6).

$$d\boldsymbol{B} = \frac{\mu_0 I di \sin\theta}{4\pi r^2} = \frac{\mu_0 I}{4\pi}\frac{x_p}{\left\{\chi_p{}^2+(y_p+y\prime)^2\right\}^{3/2}} \qquad (6)$$

Next, the magnetic flux density is calculated using the imaginary current line 311. As illustrated in FIG. 9C, the magnetic flux density B at the point P caused by the imaginary current line 311 is obtained from the following formula (7), where LI represents the length of the imaginary current line 311.

$$\text{B}(x_P, y_P) = \frac{\mu_0 I x_P}{4\pi}\int_0^{L_1}\frac{1}{(x_P{}^2+(y_P-y')^2)^{3/2}}dy' = \frac{\mu_0 I}{4\pi x_P}\left[\frac{L_I-y_p}{\left\{(L_I-y_p)^2+x_p{}^2\right\}^{1/2}} - \frac{-y_p}{(y_p{}^2-\chi_p{}^2)^{1/2}}\right] \qquad (7)$$

Thereafter, the magnetic flux passing through the closed loop (inside the current path) is calculated using one imaginary current line 311. As illustrated in FIG. 9D, the magnetic flux φ is obtained as shown in the following formula (8) for a plane CDEF (area surrounded by the imaginary current line 311, the wires 312, and the bus bar 313) near the battery cell 301.

$$\psi = \int_{x_R}^{x_R+L_\chi} \int_{y_R}^{y_R+L_y} B(x_P, y_P) dy_P dx_P \qquad (8)$$

The following formula (9) is obtained by integrating the above formula in the y-axis direction.

$$B(\chi_P) = \int_{y_R}^{y_R+L_y} B(x_P, y_P) dy_P = \frac{\mu_0 I}{4\pi x_P} \left\{ -\left(L_1^2 + x_p^2\right)^{1/2} + \left(L_2^2 + x_p^2\right)^{1/2} + \left(L_3^2 + \right.\right.$$

$$\left. x_p^2\right)^{1/2} - \left(L_4^2 + x_p^2\right)^{1/2} \right\} \qquad (9)$$

$L_1$, $L_2$, $L_3$, and $L_4$ are given as follows.

$$L_1 = L_I - y_R - L_y$$

$$L_2 = L_I - y_R$$

$$L_3 = y_R + L_y$$

$$L_4 = y_R$$

Thereafter, the above formula is integrated in the x-axis direction. In the case of the battery cell 301, $x_R$ is replaced with the radius R of the imaginary current line 311 as in the following formula (10).

$$\psi = \int_{x_R}^{x_R+L_\chi} B(x_P) dx_p = \int_{R}^{R+L_\chi} B(\chi_P) dx_p = \frac{\mu_0 I}{8\pi} \left[ -g(L_1, x_p) + g(L_2, x_p) + g(L_3, x_p) - g(L_4, x_p) \right]_{R}^{R+L_x} \qquad (10)$$

where g (L, x) is given by the following formula (11).

$$g(L, x) = -L \ln \left( \left(L^2 + x^2\right)^{1/2} + L \right) + L \ln \left( \left(L^2 + x^2\right)^{1/2} - L \right) + 2\left(L^2 + x^2\right)^{1/2} \qquad (11)$$

Subsequently, the external inductance is calculated. As shown in the following formula (12), the external inductance Lext_R is calculated by obtaining the magnetic flux crossing the closed loop (inside the current path) out of the magnetic flux generated by one imaginary current line 311 and dividing the obtained magnetic flux by the current I.

$$L_{ext\_R} = n \frac{\psi}{I} \qquad (12)$$

The following formula (13) is obtained by substituting ψ derived by the above formula (10) for the flux linkage. It is herein assumed that the number of turns of the coil is 1.

$$L_{ext\_R} = \frac{\mu_0}{8\pi}\left[-g(L_1, x_p) + g(L_2, x_p) + g(L_3, x_p) - g(L_4, x_p)\right]_R^{R+L_x} \qquad (13)$$

From the above formula, Lext_R can be given by the following formula (14) as a function that changes with the radius R of the imaginary current line 311.

$$L_{ext\_R} = h(R) \qquad (14)$$

The external inductance due to a current flowing through the wires 312 and the bus bar 313 is calculated using the actual dimensions. By applying the Biot-Savart law in a manner similar to that described above, the magnetic flux generated from the wires 312 and the bus bar 313 is calculated, and the total magnetic flux crossing the closed loop (inside the current path) is obtained. The overall external inductance Lext of the closed loop is obtained by adding Lext_R after dividing the magnetic flux by the current I. Like the calculation result of the external inductance Lext_R of the imaginary current line 311, the overall external inductance of the closed loop is given by the following formula (15) as a function of the radius R of the imaginary current line 311.

$$L_{ext} = H(R) \qquad (15)$$

Thereafter, the calculation formula (relational formula) of the self-inductance is obtained. The self-inductance Lcal is obtained by the sum of the external inductance Lext and Lint, and can be given by the following formula (16), where Lint represents the internal inductance of the battery cell 301.

$$L_{cal} = L_{ext} + L_{int} = H(R) + L_{int} \qquad (16)$$

Assuming the internal inductance Lint is also a variable, the self-inductance Lcal of the path is a function of R and Lint, and can be given by the following formula (17).

$$L_{cal} = f(R, L_{int}) \qquad (17)$$

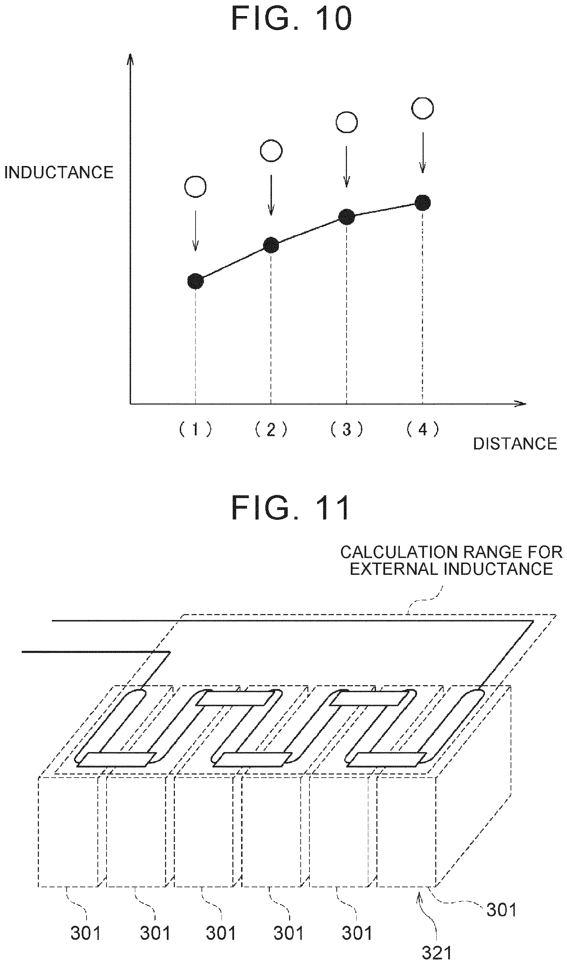

FIGS. 10 and 11 are fourth and fifth diagrams illustrating the data processing method according to the embodiment;

In a third step (step ST3) shown in FIG. 3, the determination unit 204 of the data processing device 200 determines the variables by fitting the inductance obtained from the calculation formula to the inductance measured in the first step by varying the variables in the calculation formula derived in the second step.

As an example, the determination unit 204 fits (substantially fits) the inductance (self-inductance) obtained from the relational formula (calculation formula) derived in the second step to the inductance (self-inductance) measured in the first step as illustrated in FIG. 10 by varying the value of the radius R of the imaginary current line 311 and the value of the internal inductance Lint of the battery cell 301 in the relational formula (calculation formula) derived in the second step. The determination unit 204 determines that the radius R of the imaginary current line 311 and the internal inductance Lint when the inductance obtained from the relational formula (calculation formula) derived in the second step is fitted (substantially fitted) to the inductance measured in the first step are the values to be used in a fourth step described below. In FIG. 10, the abscissa represents the wiring distance (wiring distances in the patterns (1) to (4)), and the ordinate represents the inductance (self-inductance).

In the fourth step (step ST4) shown in FIG. 3, the estimation unit 205 of the data processing device 200 estimates the self-inductance according to the wire (wiring route) of the assembled battery and the number of battery cells 301 that are based on the assembled battery information, by using the variables determined in the third step. In this case, the estimation unit 205 calculates the external inductance of the path based on, for example, the radius that is the variable for the imaginary current line 311 determined in the third step. The estimation unit 205 calculates the internal inductance of the assembled battery by, for example, adding the internal inductance of the battery cell 301 determined in the third step the same number of times as the number of battery cells 301 in the assembled battery. The estimation unit 205 estimates the self-inductance of the assembled battery 321 (see FIG. 11) (according to the number of battery cells 301 in the assembled battery) by, for example, adding the external inductance and internal inductance calculated as described above.

As an example, the estimation unit 205 calculates the external inductance of the assembled battery 321 from the calculation of the flux linkage of the current flowing in the closed circuit by using the radius R of the imaginary current line 311 determined in the third step. The estimation unit 205 obtains the internal inductance of the assembled battery 321 by adding the internal inductance Lint of the battery cell 301 determined in the third step the same number of times as the number of battery cells 301 in the assembled battery 321 as illustrated in FIG. 11. That is, the estimation unit 205 calculates "(internal inductance of assembled battery) = (internal inductance Lint of battery cell determined in third step) × (number of battery cells)." The estimation unit 205 obtains the self-inductance of the path including the assembled battery 321 by adding the external inductance and the internal inductance.

Modifications

In the above embodiment, two series cells are illustrated as an example of the predetermined number of units of battery cells 301. In the present disclosure, however, the predetermined number of units of battery cells 301 are not limited to the two series cells, and may be a single battery cell or three or more series cells. FIG. 5 shows an example in which the measurement results of the inductance are plotted on the relationship between the distance and the inductance, and FIG. 10 shows an example in which the inductances obtained from the calculation formula and the measurement results of the inductance are plotted on the relationship between the distance and the inductance in order to perform fitting. In the present disclosure, however, it is not necessary to plot the measurement results etc. on the relationship between the distance and the inductance. In the above embodiment, when approximating the battery cell 301 to an imaginary current line, the imaginary current line is assumed to be cylindrical. In the present disclosure, however, the shape of the imaginary current line is not limited to the cylindrical shape, and may be other shapes. The imaginary current line is not limited to the linear approximation. That is, the variable is not limited to the radius R of the imaginary current line, and may be various variables according to the imaginary current line. The above embodiment illustrates an example in which the wire (wiring route) is placed parallel to a terminal face of the battery cell 301. However, the present disclosure is not limited to the example in which the wire (wiring route) is located parallel to the terminal face, and the wire (wiring route) may be placed in a manner other than parallel to the terminal face.

The units of the data processing device 200 described above may be implemented as functions of an arithmetic processing unit of a computer etc. That is, the acquisition unit 202, derivation unit 203, determination unit 204, estimation unit 205, and output control unit 206 (control unit 201) of the data processing device 200 may be implemented as an acquisition function, derivation function, determination function, estimation function, and output control function (control function) of an arithmetic processing unit of a computer etc., respectively. The estimation program for the assembled battery can cause the computer to implement the above functions. The estimation program for the assembled battery may be recorded on, for example, a computer readable non-transitory recording medium such as memory, solid state drive, hard disk drive, or optical disc. As described above, each unit of the data processing device 200 may be implemented by an arithmetic processing unit of a computer etc. The arithmetic processing unit etc. are configured by, for example, an integrated circuit etc. Therefore, each unit of the data processing device 200 may be implemented as a circuit forming the arithmetic processing unit etc. That is, the acquisition unit 202, derivation unit 203, determination unit 204, estimation unit 205, and output control unit 206 (control unit 201) of the data processing device 200 may be implemented as an acquisition circuit, derivation circuit, determination circuit, estimation circuit, and output control circuit (control circuit) that form an arithmetic processing unit of a computer etc. The communication unit 211, storage unit 212, and display unit 213 (output unit) of the data processing device 200 may be implemented as, for example, a communication function, storage function, and display function (output function) including functions of an arithmetic processing unit of a computer etc. The communication unit 211, storage unit 212, and display unit 213 (output unit) of the data processing device 200 may be implemented as a communication circuit, storage circuit, and display circuit (output circuit) by configuring these units by integrated circuits etc. The communication unit 211, storage unit 212, and display unit 213 (output unit) of the data processing device 200 may be configured as a communication device, storage device, and display device (output device) by configuring these units by a plurality of devices.

The data processing device 200 may include a combination of one or more of the units described above. The term "information" as used in the present disclosure can be replaced with "data," and the term "data" can be replaced with "information."

Aspects and Effects of Embodiment

Next, aspects of the above embodiment and effects of each aspect will be described. The above embodiment is not limited to the aspects described below, and may be implemented by combining the various units described above as appropriate. The effects described below are by way of illustration only, and the effects of each aspect are not limited to those described below.

First Aspect

In an estimation method for an assembled battery of an aspect that is a data processing method, the measurement device performs: a first step of measuring inductance of a path including a predetermined number of units of battery cells and a wire connected to the battery cells; a second step of deriving a calculation formula for calculating inductance of a path on an assumption that a current flowing through the predetermined number of units of battery cells is an imaginary current line, the path including the imaginary current line and a wire connected to the imaginary current line; a third step of determining a variable by adjusting the inductance obtained from the calculation formula to the inductance measured in the first step by varying a variable of the calculation formula derived in the second step; and a fourth step of estimating self-inductance according to the wire of the assembled battery and the number of battery cells by using the variable determined in the third step. By this estimation method for the assembled battery, the inductance (self-inductance) of the assembled battery can be estimated at the design stage before actually manufacturing the assembled battery. In the estimation method for the assembled battery, the inductance including the wire connected to the battery cells is measured in the first step, the calculation formula for calculating the inductance including the wire connected to the imaginary current line is derived in the second step, and the two inductances are fitted. Accordingly, the self-inductance of the assembled battery can be estimated in consideration of the inductance of the wire (external inductance). Since a current flows through the battery cells in a complicated three-dimensional manner, it is conventionally difficult to express the three-dimensional path (current path) of the current flowing through the battery cells as a numerical formula. In this respect, in the data processing method (estimation method for the assembled battery) of the present embodiment, the calculation formula can be derived by approximating the battery cells to the imaginary current line.

Second Aspect

In the estimation method for the assembled battery of the above aspect, the calculation formula derived in the second step may include a variable for the imaginary current line and a variable for internal inductance of the battery cell. In the estimation method for the assembled battery, variable elements for the battery cells are used as variables, and the inductance of the assembled battery can be estimated by fitting the inductance derived in the second step to the inductance measured in the first step by varying the variables.

Third Aspect

In the estimation method for the assembled battery of the above aspect, in the second step, the imaginary current line may be assumed to be cylindrical, and the variable for the imaginary current line may be a radius of the imaginary current line. In the estimation method for the assembled battery, the inductance of the assembled battery can thus be estimated by using the radius of the imaginary current line as one of the variables.

Fourth Aspect

In the estimation method for the assembled battery of the above aspect, in the fourth step, self-inductance according to the number of battery cells in the assembled battery may be estimated by: calculating external inductance of the path based on the radius that is the variable for the imaginary current line determined in the third step; calculating internal inductance of the assembled battery by adding the internal inductance of the battery cell determined in the third step the same number of times as the number of battery cells in the assembled battery; and adding the external inductance and the internal inductance. In the estimation method for the assembled battery, the inductance (self-inductance) of the assembled battery can thus be based on the inductance of the predetermined number of units of battery cells.

Fifth Aspect

In the estimation method for the assembled battery of the above aspect, in the first step, the inductance may be measured using a plurality of wiring patterns of the wire connected to the battery cells. In the estimation method for the assembled battery, the inductance (self-inductance) of the assembled battery including the external inductance of the wire connected to the battery cells can thus be estimated. The self-inductance, that is, the sum of the external inductance and the internal inductance, varies with the pattern of the wire connected to the battery cells. In the estimation method for the assembled battery, however, the inductance is measured using a plurality of wiring patterns of the wire connected to the battery cells in the first step, and the adjustment (fitting) in the third step is made according to the pattern of the wire. Accordingly, the inductance (self-inductance) closer to that of an actual assembled battery can be estimated.

Sixth Aspect

A data processing device of an aspect includes: an acquisition unit configured to acquire measurement information on measured inductance of a path and assembled battery information, the path including a predetermined number of units of battery cells and a wire connected to the battery cells; a derivation unit configured to derive a calculation formula for calculating inductance of a path on an assumption that a current flowing through the predetermined number of units of battery cells is an imaginary current line, the path including the imaginary current line and a wire connected to the imaginary current line; a determination unit configured to determine a variable by adjusting the inductance obtained from the calculation formula to the inductance that is based on the measurement information acquired by the acquisition unit by varying a variable of the calculation formula derived by the derivation unit; and an estimation unit configured to estimate self-inductance according to the wire of the assembled battery and the number of battery cells by using the variable determined by the determination unit. The data processing device thus has effects similar to those of the estimation method for the assembled battery of the above aspect.

Seventh Aspect

A non-transitory storage medium of an aspect stores instructions that cause one or more processors to perform: an acquisition function to acquire measurement information on measured inductance of a path and assembled battery information, the path including a predetermined number of units of battery cells and a wire connected to the battery cells; a derivation function to derive a calculation formula for calculating inductance of a path on an assumption that a current flowing through the predetermined number of units of battery cells is an imaginary current line, the path including the imaginary current line and a wire connected to the imaginary current line; a determination function to determine a variable by adjusting the inductance obtained from the calculation formula to the inductance that is based on the measurement information acquired by the acquisition function by varying a variable of the calculation formula derived by the derivation function; and an estimation function to estimate self-inductance according to the wire of the assembled battery and the number of battery cells by using the variable determined by the determination function. The non-transitory storage medium thus has effects similar to those of the estimation method for the assembled battery of the above aspect.

**Claims**

1. An estimation method for an assembled battery (321), the estimation method comprising:

   a first step of measuring first inductance of a first path, the first path including a predetermined number of units of battery cells (301) and a wire (302) connected to the battery cells;
   a second step of deriving a calculation formula for calculating second inductance of a second path on an assumption that a current flowing through the predetermined number of units of the battery cells (301) is an imaginary current line (311), the second path including the imaginary current line (311) and a wire (312) connected to the imaginary current line (311);
   a third step of determining a second variable by adjusting the second inductance obtained from the calculation formula to the first inductance measured in the first step by varying a first variable of the calculation formula derived in the second step; and
   a fourth step of estimating self-inductance according to a wire of the assembled battery (321) and the number of the battery cells (301) by using the second variable determined in the third step.

2. The estimation method for the assembled battery (321) according to claim 1, wherein the calculation formula derived in the second step includes a variable for the imaginary current line (311) and a variable for internal inductance of the battery cell (301).

3. The estimation method for the assembled battery (321) according to claim 2, wherein in the second step, the imaginary current line (311) is assumed to be cylindrical, and the variable for the imaginary current line (311) is a radius of the imaginary current line (311).

4. The estimation method for the assembled battery (321) according to claim 3, wherein in the fourth step, self-inductance according to the number of the battery cells (301) in the assembled battery (321) is estimated by: calculating external inductance of the first path based on the radius that is the variable for the imaginary current line (311) determined in the third step; calculating internal inductance of the assembled battery (321) by adding the internal inductance of the battery cell (301) determined in the third step the same number of times as the number of the battery cells (301) in the assembled battery (321); and adding the external inductance and the internal inductance.

5. The estimation method for the assembled battery (321) according to claim 1 or 2, wherein in the first step, the first inductance is measured using a plurality of wiring patterns of the wire (302) connected to the battery cells (301).

6. A data processing device (200), comprising:

an acquisition unit (202) configured to acquire measurement information on measured first inductance of a first path and assembled battery information, the first path including a predetermined number of units of battery cells (301) and a wire (302) connected to the battery cells (301);
a derivation unit (203) configured to derive a calculation formula for calculating second inductance of a second path on an assumption that a current flowing through the predetermined number of units of the battery cells (301) is an imaginary current line (311), the second path including the imaginary current line (311) and a wire (312) connected to the imaginary current line (311);
a determination unit (204) configured to determine a second variable by adjusting the second inductance obtained from the calculation formula to the first inductance that is based on the measurement information acquired by the acquisition unit (202) by varying a first variable of the calculation formula derived by the derivation unit (203); and
an estimation unit configured to estimate self-inductance according to a wire of an assembled battery (321) and the number of the battery cells (301) by using the second variable determined by the determination unit (204).

7. A non-transitory storage medium storing instructions that are executable by one or more processors and that cause the one or more processors to perform functions comprising:

an acquisition function to acquire measurement information on measured first inductance of a first path and assembled battery information, the first path including a predetermined number of units of battery cells (301) and a wire (302) connected to the battery cells (301);
a derivation function to derive a calculation formula for calculating second inductance of a second path on an assumption that a current flowing through the predetermined number of units of the battery cells (301) is an imaginary current line (311), the second path including the imaginary current line (311) and a wire (312) connected to the imaginary current line (311);
a determination function to determine a second variable by adjusting the second inductance obtained from the calculation formula to the first inductance that is based on the measurement information acquired by the acquisition function by varying a first variable of the calculation formula derived by the derivation function; and
an estimation function to estimate self-inductance according to a wire of an assembled battery (321) and the number of the battery cells (301) by using the second variable determined by the determination function.

**Patentansprüche**

1. Ein Schätzverfahren für eine zusammengesetzte Batterie (321), wobei das Schätzverfahren Folgendes umfasst:

einen ersten Schritt des Messens der ersten Induktivität eines ersten Weges, wobei der erste Weg eine vorab festgelegte Anzahl von Einheiten von Batteriezellen (301) und einen mit den Batteriezellen verbundenen Draht (302) umfasst;
einen zweiten Schritt des Ableitens einer Berechnungsformel zum Berechnen einer zweiten Induktivität eines zweiten Weges unter der Annahme, ein Strom, der durch die vorab festgelegte Anzahl von Einheiten der Batteriezellen (301) fließt, sei eine imaginäre Stromleitung (311), wobei der zweite Weg die imaginäre Stromleitung (311) und einen Draht (312) umfasst, der mit der imaginären Stromleitung (311) verbunden ist;
einen dritten Schritt des Bestimmens einer zweiten Variablen durch Anpassen der aus der Berechnungsformel erhaltenen zweiten Induktivität an die im ersten Schritt gemessene erste Induktivität durch Variieren einer ersten Variablen der im zweiten Schritt abgeleiteten Berechnungsformel; und
einen vierten Schritt des Schätzens der Eigeninduktivität passend zu einem Draht der zusammengesetzten Batterie (321) und der Anzahl der Batteriezellen (301) unter Nutzung der im dritten Schritt bestimmten zweiten Variablen.

2. Schätzverfahren für die zusammengesetzte Batterie (321) nach Anspruch 1, wobei die im zweiten Schritt abgeleitete Berechnungsformel eine Variable für die imaginäre Stromleitung (311) und eine Variable für die innere Induktivität der Batteriezelle (301) umfasst.

3. Schätzverfahren für die zusammengesetzte Batterie (321) nach Anspruch 2, wobei im zweiten Schritt angenommen wird, dass die imaginäre Stromleitung (311) zylindrisch ist, und die Variable für die imaginäre Stromleitung (311) ein Radius der imaginären Stromleitung (311) ist.

4. Schätzverfahren für die zusammengesetzte Batterie (321) nach Anspruch 3, wobei im vierten Schritt die Eigeninduktivität entsprechend der Anzahl der Batteriezellen (301) in der zusammengesetzten Batterie (321) geschätzt wird durch: Berechnen der äußeren Induktivität des ersten Weges basierend auf dem Radius, der die Variable für die imaginäre Stromleitung (311) ist, die im dritten Schritt bestimmt wurde; Berechnen der Eigeninduktivität der zusammengesetzten Batterie (321) durch Addieren der inneren Induktivität der Batteriezelle (301), die im dritten Schritt bestimmt wurde, so oft wie die Anzahl der Batteriezellen (301) in der zusammengesetzten Batterie (321); und Addieren der äußeren Induktivität und der inneren Induktivität.

5. Schätzverfahren für die zusammengesetzte Batterie (321) nach Anspruch 1 oder 2, wobei im ersten Schritt die erste Induktivität unter Verwendung einer Vielzahl von Verdrahtungsmustern des mit den Batteriezellen (301) verbundenen Drahtes (302) gemessen wird.

6. Eine Datenverarbeitungsvorrichtung (200), die Folgendes umfasst:

   eine Erfassungseinheit (202), die dazu aufgebaut ist, Messinformationen über die gemessene erste Induktivität eines ersten Weges und zusammengesetzte Batterieinformationen zu erfassen, wobei der erste Weg eine vorab festgelegte Anzahl von Einheiten von Batteriezellen (301) und einen mit den Batteriezellen (301) verbundenen Draht (302) umfasst;

   eine Ableitungseinheit (203), die dazu aufgebaut ist, eine Berechnungsformel zum Berechnen der zweiten Induktivität eines zweiten Weges unter der Annahme abzuleiten, ein Strom, der durch die vorab festgelegte Anzahl von Einheiten der Batteriezellen (301) fließt, sei eine imaginäre Stromleitung (311), wobei der zweite Weg die imaginäre Stromleitung (311) und einen Draht (312) umfasst, der mit der imaginären Stromleitung (311) verbunden ist;

   eine Bestimmungseinheit (204), die dazu aufgebaut ist, eine zweite Variable zu bestimmen, indem sie die zweite Induktivität, die aus der Berechnungsformel erhalten wird, an die erste Induktivität anpasst, die auf der Messinformation basiert, die von der Erfassungseinheit (202) erfasst wird, indem sie eine erste Variable der durch die Ableitungseinheit (203) abgeleiteten Berechnungsformel variiert; und

   eine Schätzeinheit, die dazu aufgebaut ist, die Eigeninduktivität passend zu einem Draht einer zusammengesetzten Batterie (321) und der Anzahl der Batteriezellen (301) unter Verwendung der von der Bestimmungseinheit (204) bestimmten zweiten Variablen zu schätzen.

7. Nichtflüchtiges Speichermedium, das Befehle speichert, die von einem oder mehreren Prozessoren ausführbar sind und die den einen oder die mehreren Prozessoren veranlassen, Funktionen auszuführen, die Folgendes umfassen:

   eine Erfassungsfunktion zum Erfassen von Messinformationen über eine gemessene erste Induktivität eines ersten Weges und von Informationen über eine zusammengesetzte Batterie, wobei der erste Weg eine vorab festgelegte Anzahl von Einheiten von Batteriezellen (301) und einen mit den Batteriezellen (301) verbundenen Draht (302) umfasst;

   eine Ableitungsfunktion zum Ableiten einer Berechnungsformel zum Berechnen einer zweiten Induktivität eines zweiten Weges unter der Annahme, dass ein Strom, der durch die vorab festgelegte Anzahl von Einheiten der Batteriezellen (301) fließt, eine imaginäre Stromleitung (311) ist, wobei der zweite Weg die imaginäre Stromleitung (311) und einen mit der imaginären Stromleitung (311) verbundenen Draht (312) umfasst;

   eine Bestimmungsfunktion zum Bestimmen einer zweiten Variablen durch Anpassen der aus der Berechnungsformel erhaltenen zweiten Induktivität an die erste Induktivität, die auf der durch die Erfassungsfunktion erfassten Messinformation basiert, durch Variieren einer ersten Variablen der durch die Ableitungsfunktion abgeleiteten Berechnungsformel; und

   eine Schätzfunktion zum Schätzen der Eigeninduktivität passend zu einem Draht einer zusammengesetzten Batterie (321) und der Anzahl der Batteriezellen (301) unter Nutzung der durch die Bestimmungsfunktion bestimmten zweiten Variablen.

**Revendications**

1. Procédé d'estimation pour une batterie assemblée (321), le procédé d'estimation comprenant :

   une première étape consistant à mesurer une première inductance d'un premier trajet, le premier trajet incluant un nombre prédéterminé d'unités de cellules de batterie (301) et un fil (302) raccordé aux cellules de batterie ;
   une deuxième étape consistant à dériver une formule de calcul pour calculer une seconde inductance d'un second trajet en supposant qu'un courant circulant à travers le nombre prédéterminé d'unités des cellules de batterie (301) est une ligne de courant imaginaire (311), le second trajet incluant la ligne de courant imaginaire (311) et un fil (312) raccordé à la ligne de courant imaginaire (311) ;
   une troisième étape consistant à déterminer une seconde variable en ajustant la seconde inductance obtenue à partir de la formule de calcul à la première inductance mesurée lors de la première étape en faisant varier une première variable de la formule de calcul dérivée dans la deuxième étape ; et
   une quatrième étape consistant à estimer l'auto-inductance en fonction d'un fil de la batterie assemblée (321) et du nombre de cellules de batterie (301) en utilisant la seconde variable déterminée dans la troisième étape.

2. Procédé d'estimation pour la batterie assemblée (321) selon la revendication 1, dans lequel la formule de calcul dérivée dans la deuxième étape comprend une variable pour la ligne de courant imaginaire (311) et une variable pour l'inductance interne de la cellule de batterie (301).

3. Procédé d'estimation pour la batterie assemblée (321) selon la revendication 2, dans lequel, dans la deuxième étape, la ligne de courant imaginaire (311) est supposée être cylindrique et la variable pour la ligne de courant imaginaire (311) est un rayon de la ligne de courant imaginaire (311).

4. Procédé d'estimation pour la batterie assemblée (321) selon la revendication 3, dans lequel, dans la quatrième étape, l'auto-inductance en fonction du nombre de cellules de batterie (301) dans la batterie assemblée (321) est estimée : en calculant l'inductance externe du premier trajet sur la base du rayon qui est la variable pour la ligne de courant imaginaire (311) déterminée dans la troisième étape ; en calculant l'inductance interne de la batterie assemblée (321) en ajoutant l'inductance interne de la cellule de batterie (301) déterminée dans la troisième étape le même nombre de fois que le nombre de cellules de batterie (301) dans la batterie assemblée (321) ; et en ajoutant l'inductance externe et l'inductance interne.

5. Procédé d'estimation pour la batterie assemblée (321) selon la revendication 1 ou 2, dans lequel, dans la première étape, la première inductance est mesurée à l'aide d'une pluralité de motifs de câblage du fil (302) raccordé aux cellules de batterie (301).

6. Dispositif de traitement de données (200), comprenant :

   une unité d'acquisition (202) configurée pour acquérir des informations de mesure sur une première inductance mesurée d'un premier trajet et des informations de batterie assemblées, le premier trajet incluant un nombre prédéterminé d'unités de cellules de batterie (301) et un fil (302) raccordé aux cellules de batterie (301) ;
   une unité de dérivation (203) configurée pour dériver une formule de calcul pour calculer une seconde inductance d'un second trajet en supposant qu'un courant circulant à travers le nombre prédéterminé d'unités des cellules de batterie (301) est une ligne de courant imaginaire (311), le second trajet incluant la ligne de courant imaginaire (311) et un fil (312) raccordé à la ligne de courant imaginaire (311) ;
   une unité de détermination (204) configurée pour déterminer une seconde variable en ajustant la seconde inductance obtenue à partir de la formule de calcul à la première inductance qui est basée sur les informations de mesure acquises par l'unité d'acquisition (202) en faisant varier une première variable de la formule de calcul dérivée par l'unité de dérivation (203) ; et
   une unité d'estimation configurée pour estimer l'auto-inductance en fonction d'un fil d'une batterie assemblée (321) et du nombre de cellules de batterie (301) en utilisant la seconde variable déterminée par l'unité de détermination (204).

7. Support non transitoire lisible par ordinateur stockant des instructions qui sont exécutables par un ou plusieurs processeurs et qui amènent les un ou plusieurs processeurs à effectuer des fonctions comprenant :

   une fonction d'acquisition pour acquérir des informations de mesure sur une première inductance mesurée d'un premier trajet et des informations de batterie assemblées, le premier trajet incluant un nombre prédéterminé d'unités de cellules de batterie (301) et un fil (302) raccordé aux cellules de batterie (301) ;

une fonction de dérivation pour dériver une formule de calcul pour calculer une seconde inductance d'un second trajet en supposant qu'un courant circulant à travers le nombre prédéterminé d'unités des cellules de batterie (301) est une ligne de courant imaginaire (311), le second trajet incluant la ligne de courant imaginaire (311) et un fil (312) raccordé à la ligne de courant imaginaire (311) ;

une fonction de détermination pour déterminer une seconde variable en ajustant la seconde inductance obtenue à partir de la formule de calcul à la première inductance qui est basée sur les informations de mesure acquises par la fonction d'acquisition en faisant varier une première variable de la formule de calcul dérivée par la fonction de dérivation ; et

une fonction d'estimation pour estimer l'auto-inductance en fonction d'un fil d'une batterie assemblée (321) et du nombre de cellules de batterie (301) en utilisant la seconde variable déterminée par la fonction de détermination.

# FIG. 1

MEASUREMENT DEVICE 100

200

1

301 301 301 301 301 301

302

# FIG. 2

200

201

| 211 | COMMUNICATION UNIT |
| 212 | STORAGE UNIT |
| 213 | DISPLAY UNIT |

ACQUISITION UNIT — 202

DERIVATION UNIT — 203

DETERMINATION UNIT — 204

ESTIMATION UNIT — 205

OUTPUT CONTROL UNIT — 206

# FIG. 3

START

MEASURE INDUCTANCE OF
PATH INCLUDING BATTERY
CELLS AND WIRE — ST1

DERIVE CALCULATION
FORMULA FOR CALCULATING
INDUCTANCE OF PATH — ST2

DETERMINE VARIABLES — ST3

ESTIMATE SELF-INDUCTANCE — ST4

END

# FIG. 4

# FIG. 5

# FIG. 6

$$Lcal = f ( R, Lint )$$

# FIG. 7A

401A

t

# FIG. 7B

401B

t

FIG. 8A

FIG. 8B

FIG. 8C

FIG. 9A

FIG. 9B

FIG. 9C

FIG. 9D

# FIG. 10

# FIG. 11

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2019191030 A
- US 2014315047 A
- US 2015198675 A
- US 2019271747 A
- US 2006017447 A
- US 2012015222 A